# EUROPÄISCHE PATENTSCHRIFT

(11) **EP 2 589 146 B1**
(45) Veröffentlichungstag und Bekanntmachung des Hinweises auf die Patenterteilung: **08.04.2015**
(21) Anmeldenummer: 11721502.0
(22) Anmeldetag: 18.05.2011
(51) Int. Cl.: H03K 3/42, H03K 3/2885

(54) **ELEKTRONISCHE SCHALTUNG ZUR OPTISCHEN ANSTEUERUNG EINES FLIP FLOP**
ELECTRONIC CIRCUIT FOR OPTICAL CONTROL OF A FLIPFLOP
CIRCUIT ÉLECTRONIQUE POUR LA COMMANDE OPTIQUE D'UNE BASCULE BISTABLE

(30) Priorität: 01.07.2010 DE 102010025782
(43) Veröffentlichungstag der Anmeldung: 08.05.2013
(73) Patentinhaber: Rohde & Schwarz GmbH & Co. KG, 81671 München (DE)
(72) Erfinder: LANDOLT, Oliver, 82024 Taufkirchen (DE)
(74) Vertreter: Körfer, Thomas
(86) Internationale Anmeldenummer: PCT/EP2011/058061
(87) Internationale Veröffentlichungsnummer: WO 2012/000715

(56) Entgegenhaltungen:
- EP-A1- 0 437 740
- EP-A2- 0 517 037
- US-B1- 6 445 721
- KHALED M SHARAF ET AL: "Analysis and Optimization of Series-Gated CML and ECL High-Speed Bipolar Circuits", IEEE JOURNAL OF SOLID-STATE CIRCUITS, IEEE SERVICE CENTER, PISCATAWAY, NJ, USA, Bd. 31, Nr. 2, 1. Februar 1996 (1996-02-01), XP011060217, ISSN: 0018-9200

## Beschreibung

Die Erfindung betrifft ein optisch angesteuertes Flip-Flop, insbesondere ein Toggle-Flip-Flop wie z.B in Dokument EP 0 437 740 A1 beschrieben. Ein Phasenrauschen des Taktsignals limitiert die Leistung zahlreicher zeitdiskreter Systeme. In Analog-Digital-Wandlern resultiert ein Phasenrauschen des Taktsignals in einem Rauschen des abgetasteten Signals. Bei hohen Frequenzen überwiegt dieses Rauschen über anderweitige Rauschquellen in dem Signalpfad. In Kommunikationssystemen limitiert das Phasenrauschen des Taktsignals die untere Grenze des zeitlichen Abstands zwischen zwei aufeinanderfolgenden Symbolen. Phasenrauschen eines Taktsignals entsteht zum Teil innerhalb des Oszillators, welcher das Taktsignal erzeugt und zum Teil durch Rauschen in der weiteren Schaltung, welche das Taktsignal verteilt.

Üblicherweise wird ein Taktsignal durch einen elektronischen Oszillator, z.B. einen Quarzoszillator erzeugt. Nachteilhaft an einem solchen Oszillator ist jedoch das intrinsische Phasenrauschen des Oszillators, welches zu einem Phasenrauschen des erzeugten Taktsignals führt.

Das Dokument E.W. Jacobs, "Optically clocked track-and-hold for high-speed high-resolution analog-to-digital conversion", Proc. IEEE International Topical Meeting on Microwave Photonics, 2004, Seiten 190-192, zeigt darüber hinaus ein Halteglied (sample-and-hold device) bestehend aus einer Diodenbrücke. Dabei werden Abtastpulse optisch mittels eines modengekoppelter Lasers (mode-locked laser), dessen Ausgang gleichzeitig zwei Photodioden zugeführt wird, erzeugt. In Abwesenheit von Licht leiten zwei Stromquellen einen Ruhestrom an die Diodenbrücke. Derweil folgt der Ausgang der Diodenbrücke einem analogen abzutastenden Eingangssignal. Wenn ein Laserpuls die Photodioden trifft, unterbrechen die beiden Photodioden den Ruhestrom, welcher von den Stromquellen erzeugt wird und deaktivieren dadurch die Diodenbrücke. Der Ausgang der Diodenbrücke wird somit während der Zeitdauer des Laserpulses konstant gehalten. Das Ausgangssignal der Diodenbrücke muss auf Grund der Kürze des Laserpulses zusätzlich durch ein sekundäres Halteglied abgetastet werden, um die Zeitdauer zu erhöhen, um einen Analog-Digital-Wandler eine Digitalisierung zu ermöglichen. Die Anforderrungen an das Phasenrauschen des sekundären Halteglieds sind dabei signifikant reduziert gegenüber den Anforderungen an das primäre Halteglied. Eine elektronische Erzeugung des Takts des sekundären Halteglieds ist somit möglich. Nachteilhaft an dem dort gezeigten Halteglied ist, dass es zwei Photodioden benötigt.

Der Erfindung liegt die Aufgabe zugrunde, eine Schaltung zu schaffen, welche zu einem hochgenauen Zeitpunkt schaltet.

Die Aufgabe wird erfindungsgemäß für die Vorrichtung durch die Merkmale des unabhängigen Anspruchs 1 gelöst. Vorteilhafte Weiterbildungen sind Gegenstand der hierauf rückbezogenen Unteransprüche.

Eine bestimmte Art von Laserquellen - modengekoppelte Laser (mode-locked laser) - erzeugen eine periodische Serie von sehr kurzen Lichtpulsen. Die zeitliche Abweichung der Abstände und Zeitdauern dieser Lichtpulse ist dabei sehr gering. Es ergibt sich somit ein extrem geringes Phasenrauschen des von diesen Lichtpulsen gebildeten Signals. Insbesondere ist dieses Phasenrauschen wesentlich geringer als durch elektronische Oszillatoren erreichbar. Ein weiterer Vorteil der Laserpulse gegenüber elektronischen Taktsignalen ist, dass sie sehr einfach ohne Störungen, insbesondere elektromagnetische Einstreuungen, übertragen werden können. Insbesondere eine Freiraumübertragung oder eine Glasfaserübertragung sind möglich.

In Systemen, welche auf ein niedriges Phasenrauschen eines Takts angewiesen sind, ist eine vorteilhafte Nutzung der durch modengekoppelte Laser erzeugten Lichtpulse zur Erzeugung eines Taktsignals somit möglich. Als mögliche Anwendung ergibt sich dabei z.B. ein digitaler Empfänger in einem seriellen Hochgeschwindigkeitsdatenkommunikationssystem. Eine der Herausforderungen dieses Ansatzes ist es, dass die Lichtpulse, welche von den modengekoppelten Lasern erzeugt werden, sehr kurz sind gegenüber der Zeit zwischen den Lichtpulsen. Der überwiegende Teil der elektronischen Schaltungen benötigt jedoch ein Taktsignal, welches eine identische Zeitdauer beider Taktzustände aufweist.

Eine erfindungsgemäße elektronische Schaltung beinhaltet somit eine Kippschaltung, eine Schalteinrichtung, eine Photodiode und einem modengekoppelten Laser. Der modengekoppelte Laser erzeugt Lichtpulse, welche in der Photodiode einen Photostrom erzeugen. Die Schalteinrichtung überträgt den Photostrom an einen von zwei Eingängen der Kippschaltung. Die Kippschaltung gibt seinen Zustand an zumindest einem Ausgang aus. Eine zeitlich hochgenaue Schaltung der Schalteinrichtung und der Kippschaltung wird so erreicht.

Die Erfindung beschreibt somit eine Flip-Flop-Schaltung mit einer Photodiode. In einer vorteilhaften Ausgestaltung ändert sich der Zustand der Flip-Flop-Schaltung jedes Mal, wenn ein Lichtpuls die Photodiode trifft. Das Flip-Flop kann dabei als Toggle-Flip-Flop konfiguriert sein, dessen Zustand mit jedem Lichtpuls invertiert wird.

Nachfolgend wir die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein erstes Ausführungsbeispiel der erfindungsgemäßen Schaltung;
- Fig. 2: ein zweites Ausführungsbeispiel der erfindungsgemäßen Schaltung;
- Fig. 3: ein drittes Ausführungsbeispiel der erfindungsgemäßen Schaltung, und
- Fig. 4: ein viertes Ausführungsbeispiel der erfindungsgemäßen Schaltung.

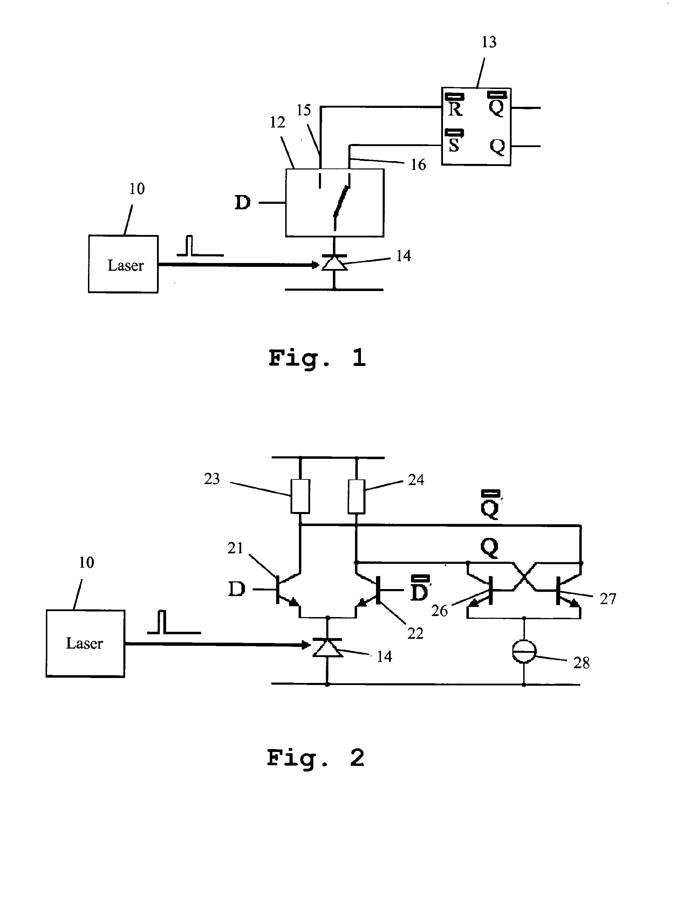

Mittels Fig. 1 bis 4 wird der Aufbau und die Funktionsweise verschiedener Formen der erfindungsgemäßen Schaltung veranschaulicht. Identische Elemente wurden in ähnlichen Abbildungen zum Teil nicht wiederholt dargestellt und beschrieben.

Ein modengekoppelter Laser 10 (mode-locked laser) erzeugt eine Serie von extrem kurzen Laserlichtpulsen. Ein Lichtpuls weist dabei eine sehr kurze Dauer von z.B. 1ps, bevorzugt zwischen 0,1ps bis 10ps auf. Der zeitliche Abstand zwischen den Pulsen ist wesentlich größer, z.B. mehrere 100ps, bevorzugt 50ps bis 10ms. Das Laserlicht wird mittels Freiraumübertragung oder einer optischen Faser, z.B. einer Glasfaser auf eine Photodiode 14 geleitet. Auch eine Kombination einer Freiraumübertragung und eines faseroptischen Übertragungssystems ist möglich. Insbesondere kann das faseroptische System an dem Substrat der Photodiode 14 angebracht seien. Die Photodiode 14 verbindet ein Schaltelement, im Folgenden auch kurz Schalter 12 genannt, mit einer negativen Versorgungsspannung, welche auch mit Masse verbunden sein kann. Der Schalter 12 verfügt weiterhin über einen Dateneingang D. Der Schalter 12 verfügt weiterhin über zwei Ausgänge 15, 16. Die beiden Ausgänge 15, 16 sind mit zwei Eingängen R' und S' eines Auffangregisters (Latch) 13 verbunden. Dieses entspricht einer Kippschaltung. Der Eingang S' dient dem setzen eines High-Zustandes. Der Eingang R' dient dem setzen eines Low-Zustandes. Das Auffangregister 13 verfügt zusätzlich über einen nicht invertierenden Ausgang Q und einen invertierenden Ausgang Q'.

Ein Lichtpuls, welcher die Photodiode 14 erreicht, erzeugt einen elektrischen Stromfluss durch die Photodiode 14. Die Position des Schalters 12 wird gleichzeitig von einem anliegenden Datensignal an dem Dateneingang D bestimmt. Wenn an dem Dateneingang D ein Low-Signal anliegt, aktiviert der Photostrom der Photodiode 14 den Eingang R' des Auffangregisters 13. Der nicht invertierende Ausgang Q des Auffangregisters 13 wird in den Zustand Low gesetzt. Wenn an dem Dateneingang D ein High-Signal anliegt, aktiviert der Photostrom der Photodiode 14 den Eingang S' des Auffangregisters 13. Der nicht invertierende Ausgang Q des Auffangregisters 13 geht somit in den Zustand High. Die gesamte in Fig. 1 gezeigte Schaltung wirkt somit als D-Flip-Flop.

Dabei werden die in dem Flip-Flop zu speichernden Daten als Datensignal dem Dateneingang D zugeführt. Die Daten werden zu dem nicht invertierenden Ausgang Q und optional zu dem invertierenden Ausgang Q' des Auffangregisters 13 übertragen, sobald ein Lichtpuls eingeht. Der Lichtpuls erfüllt dabei den Zweck einer ansteigenden Taktflanke bei herkömmlichen elektronischen D-Flip-Flop. Um eine zuverlässige Arbeitsweise zu gewährleisten, sollte der Dateneingang D für einen kurzen Moment (set up time) konstant sein, bevor der Lichtpuls eintrifft und nachdem der Lichtpuls vorüber ist.

Eine praktische Implementierung des in Fig. 1 gezeigten ersten Ausführungsbeispiels der erfindungsgemäßen Schaltung wird in Fig. 2 gezeigt. Zur Implementierung des Schalters 12 und des Auffangregisters 13 aus Fig. 1 werden hier Bipolartransistoren 21, 22, 26 und 27 eingesetzt. Die Emitter der Transistoren 21, 22 sind dabei mit der Photodiode 14 verbunden, welche ihrerseits mit einer negativen Versorgungsspannung, die auch mit Masse verbunden sein kann, verbunden. An den Basisanschlüssen der Transistoren 21, 22 sind Dateneingänge D und D', angeschlossen. An ihnen liegt das Datensignal an. Die Kollektoren der Transistoren 21, 22 sind jeweils mittels eines Widerstands 23, 24 mit einer positiven Versorgungsspannung verbunden. Die Kombination der Transistoren 21, 22 und der Widerstände 23, 24 bildet dabei den Schalter 12 aus Fig. 1.

Die Photodiode 14 ist in dieser Schaltung derart angeschlossen, dass lediglich ein minimaler Leckstrom fließt, solange kein Licht auf die Photodiode 14 fällt. Sobald Licht auf die Photodiode 14 fällt, entsteht ein Photostrom von einer n-dotierten zu einer p-dotierten Region der Photodiode 14. Die Intensität des Photostroms ist in guter Näherung proportional zu der Lichtleistung des Laserpulses. Der Schalter 12 aus Fig. 1 wird hier somit durch ein differentielles Paar von Transistoren 21, 22 gebildet, welche durch das Datensignal beaufschlagt sind.

Auch das Auffangregister 13 aus Fig. 1 wird durch ein differentielles Paar von Transistoren 26, 27 gebildet. Die Basisanschlüsse dieses differenziellen Paars sind überkreuzt mit den Kollektoranschlüssen der Transistoren 21, 22 verbunden. D.h. der Basisanschluss des Transistors 26 ist mit dem Kollektoranschluss des Transistors 21 verbunden. Der Basisanschluss des Transistors 27 ist mit dem Kollektoranschluss des Transistors 22 verbunden. Darüber hinaus ist der Kollektoranschluss des Transistors 26 mit dem Kollektoranschluss des Transistors 22 verbunden. Auch ist der Kollektoranschluss des Transistors 27 mit dem Kollektoranschluss des Transistors 21 verbunden. Die Emitteranschlüsse der Transistoren 26, 27 sind über eine Stromquelle 28 mit einer negativen Versorgungsspannung verbunden, welche auch mit Masse verbunden sein kann. Durch die Überkreuzverschaltung wird eine positive Rückkopplung erzeugt und somit der logische Zustand des Auffangregisters aufrechterhalten. Der von einer Stromquelle 28 erzeugte Ruhestrom des Auffangregisters muss dabei deutlich geringer sein, als der Photostrom welcher von der Photodiode 14 erzeugt wird. Nur wenn diese Bedingung erfüllt ist, kann der Photostrom der Photodiode 14 den Ruhestrom der Stromquelle 28 übertreffen und damit den logischen Zustand des Auffangregisters ändern.

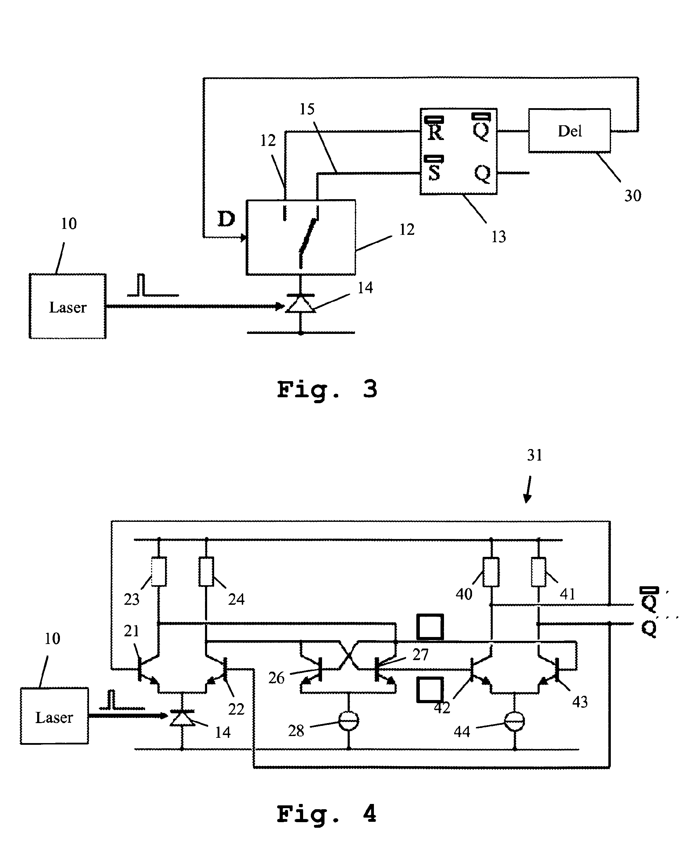

Das hier gezeigte optisch angesteuerte D-Flip-Flop kann für eine Vielzahl von Anwendungen eingesetzt werden. Insbesondere bittet es sich für eine Anwendung in einem hochgenauen Taktgenerator an. Ein solcher hochgenauer Taktgenerator wird in Fig. 3 gezeigt. Um ein Taktsignal zu erzeugen, dessen Taktzustände die gleiche Länge aufweisen, wird der invertierende Ausgang Q' des Auffangregisters 13 über eine Verzögerungseinrichtung 30 zu dem Dateneingang D des Schalters 12 zurückgekoppelt. Um einen stabilen Betrieb zu gewährleisten, verzögert die Verzögerungseinrichtung 30 das invertierte Signal Q' zumindest für die Dauer eines Laserpulses. Nachdem die Länge eines Laserpulses sehr gering ist, z.B. 1ps oder wenige ps, genügt eine geringe Verzögerung durch die Verzögerungseinrichtung 30. Es entsteht somit ein Taktsignal, dessen Taktzustände jeweils 50 % des Taktes einnehmen. Die Frequenz des Taktsignals entspricht dabei der halben Pulsfrequenz des Lasers 10. Ohne die Verzögerungseinrichtung 30 könnte sich ein instabiler Zustand ergeben.

In Fig. 4 wird eine praktische Ausführung der in Fig. 3 gezeigten Schaltung mittels Bipolartransistoren gezeigt. Die Schaltung entspricht dabei weitgehend der in Fig. 2 gezeigten Schaltung. Zusätzlich wurde eine Verzögerungseinrichtung 31 hinzugefügt. Die Verzögerungseinrichtung 31 besteht aus zwei Transistoren 42, 43, einer Stromquelle 44 und zwei Widerständen 40, 41. Die beiden Widerstände 40, 41 sind dabei jeweils zwischen eine positive Versorgungsspannung und den Kollektor eines der Transistoren 42, 43 als Lastwiderstände geschaltet. Die Emitter der Transistoren 42, 43 sind jeweils mit der Stromquelle 44 verbunden, welche gegen eine negative Versorgungsspannung, welche auch mit Masse verbunden sein kann, geschaltet ist. Die Basis des Transistors 42 ist mit der Basis des Transistors 27 verbunden. Die Basis des Transistors 43 ist mit der Basis des Transistors 26 verbunden. Darüber hinaus ist der Kollektor des Transistors 42 mit der Basis des Transistors 21 als Rückkopplung verbunden. Ebenso ist der Kollektor des Transistors 43 mit der Basis des Transistors 42 verbunden.

Die Erfindung ist nicht auf das dargestellte Ausführungsbeispiel beschränkt. Alle vorstehend beschriebenen Merkmale oder in den Figuren gezeigten Merkmale sind im Rahmen der Erfindung beliebig vorteilhaft miteinander kombinierbar. Statt NPN Bipolar Transistoren können ebenso andere Transistoren, z.B. PNP Bipolar Transistoren, NMOS oder PMOS Transistoren oder sogar weitere FET Transistoren eingesetzt werden.

## Patentansprüche

1. Elektronische Schaltung mit einer Kippschaltung (13), einer Schalteinrichtung (12), einer Photodiode (14) und einem modengekoppelten Laser (10),
wobei der modengekoppelte Laser (10) Lichtpulse erzeugt, wobei die Lichtpulse in der Photodiode (14) einen Photostrom erzeugen,
wobei die Schalteinrichtung (12) den Photostrom an einen von zwei Eingängen (R', S') der Kippschaltung (13) direkt oder indirekt überträgt, und
wobei die Kippschaltung (13) ihren Zustand an zumindest einem Ausgang (Q, Q') ausgibt,
**dadurch gekennzeichnet,**
**dass** die Schalteinrichtung (12) den Photostrom in Abhängigkeit einer Schaltstellung an einen der zwei Eingänge (R', S') der Kippschaltung (13) überträgt, und dass die Schaltstellung der Schalteinrichtung (12) von einem Signal an einem Dateneingang (D, D') des Schalters (12) abhängt.

2. Elektronische Schaltung nach Anspruch 1,
**dadurch gekennzeichnet,**
**dass** die Schalteinrichtung (12) aus einem differentiellen Paar von ersten Transistoren (21, 22) und zwei Lastwiderständen (23, 24) besteht,
**dass** die Lastwiderstände (23, 24) zwischen einen Versorgungsspannungsanschluss und Kollektoren der ersten Transistoren (21, 22) geschaltet sind, und
**dass** Emitter der ersten Transistoren (21, 22) mit der Photodiode (14) verbunden sind.

3. Elektronische Schaltung nach Anspruch 2,
**dadurch gekennzeichnet,**
**dass** Basisanschlüsse der ersten Transistoren dem Dateneingang der Schalteinrichtung (12) entsprechen.

4. Elektronische Schaltung nach Anspruch 2 oder 3,
**dadurch gekennzeichnet,**
**dass** die Kippschaltung (13) aus einem differentiellen Paar von zweiten Transistoren (26, 27) und einer ersten Stromquelle (28) besteht,
**dass** die erste Stromquelle (28) zwischen Emitter der zweiten Transistoren (26, 27) und einen Basisanschluss geschaltet ist,
**dass** Basisanschlüsse der zweiten Transistoren (26, 27) überkreuz mit Kollektoren der zweiten Transistoren (26, 27) verbunden sind, und
**dass** die Kollektoren der zweiten Transistoren (26, 27) jeweils mit einem Kollektor der ersten Transistoren (21, 22) verbunden sind.

5. Elektronische Schaltung nach Anspruch 4,
**dadurch gekennzeichnet,**
**dass** ein Photostrom der Photodiode (14) bei Bestrahlung mit einem Puls des modengekoppelten Lasers (10) größer als ein Strom der ersten Stromquelle (28) ist.

6. Elektronische Schaltung nach einem der Ansprüche 1 bis 5,
**dadurch gekennzeichnet,**
**dass** die elektronische Schaltung weiterhin über eine Verzögerungseinrichtung (30, 31) verfügt,
**dass** die Verzögerungseinrichtung (30, 31) mit einem Ausgang (Q, Q') der Kippschaltung (13) verbunden ist,
**dass** die Verzögerungseinrichtung (30, 31) weiterhin mit einem Dateneingang (D, D') der Schalteinrichtung (12) verbunden ist, und
**dass** die Verzögerungseinrichtung (30, 31) ein Ausgangssignal der Schalteinrichtung (13) verzögert an den Dateneingang (D, D') überträgt.

7. Elektronische Schaltung nach Anspruch 6,
**dadurch gekennzeichnet,**
**dass** die Verzögerung der Verzögerungseinrichtung (30, 31) länger ist als eine Pulsdauer eines Pulses des modengekoppelten Lasers (10).

8. Elektronische Schaltung nach Anspruch 6 oder 7,
**dadurch gekennzeichnet,**
**dass** die Verzögerungseinrichtung (30, 31) aus einen differentiellen Paar von dritten Transistoren (42, 43), zwei Lastwiderständen (40, 41) und einer zweiten Stromquelle (44) besteht,
**dass** die Lastwiderstände (40, 41) zwischen einen Versorgungsspannungsanschluss und Kollektoren der dritten Transistoren (42, 43) geschaltet sind,
**dass** Emitter der der dritten Transistoren (42, 43) mit der zweiten Stromquelle (44) verbunden sind, und
**dass** Basisanschlüsse der dritten Transistoren (42, 43) mit zumindest einem Ausgang (Q, Q') der Kippschaltung (13) verbunden sind.

9. Elektronische Schaltung nach Anspruch 8,
**dadurch gekennzeichnet,**
**dass** Kollektoren der dritten Transistoren (42, 43) mit Ausgängen (Q'', Q''') der elektronischen Schalteinrichtung verbunden sind.

## Claims

1. Electronic circuit comprising a multivibrator (13), a switching device (12), a photodiode (14) and a mode-locked laser (10),
wherein the mode-locked laser (10) generates light pulses,
wherein the light pulses generate a photocurrent in the photodiode (14)
wherein the switching device (12) transfers the photocurrent to one of two inputs (R', S') of the multivibrator (13) directly or indirectly, and
wherein the multivibrator (13) outputs its state at at least one output (Q, Q'),
**characterized**
**in that** the switching device (12) transfers the photocurrent to one of the two inputs (R', S') of the multivibrator (13) depending on a switching position, and
**in that** the switching position of the switching device (12) depends on a signal at a data input (D, D') of the switch (12).

2. Electronic circuit according to Claim 1,
**characterized**
**in that** the switching device (12) consists of a differential pair of first transistors (21, 22) and two load resistors (23, 24),
**in that** the load resistors (23, 24) are connected between a supply voltage terminal and collectors of the first transistors (21, 22), and
**in that** emitters of the first transistors (21, 22) are connected to the photodiode (14).

3. Electronic circuit according to Claim 2,
**characterized**
**in that** base terminals of the first transistors correspond to the data input of the switching device (12).

4. Electronic circuit according to Claim 2 or 3,
**characterized**
**in that** the multivibrator (13) consists of a differential pair of second transistors (26, 27) and a first current source (28),
**in that** the first current source (28) is connected between emitters of the second transistors (26, 27) and a base terminal,
**in that** base terminals of the second transistors (26, 27) are connected crosswise to collectors of the second transistors (26, 27), and
**in that** the collectors of the second transistors (26, 27) are respectively connected to a collector of the first transistors (21, 22).

5. Electronic circuit according to Claim 4,
**characterized**
**in that** a photocurrent of the photodiode (14) upon irradiation with a pulse of the mode-locked laser (10) is greater than a current of the first current source (28).

6. Electronic circuit according to any of Claims 1 to 5,
**characterized**
**in that** the electronic circuit furthermore has a delay device (30, 31),
**in that** the delay device (30, 31) is connected to an output (Q, Q') of the multivibrator (13),
**in that** the delay device (30, 31) is furthermore connected to a data input (D, D') of the switching device (12), and
**in that** the delay device (30, 31) transfers an output signal of the switching device (13) to the data input (D, D') in a delayed manner.

7. Electronic circuit according to Claim 6,
**characterized**
**in that** the delay of the delay device (30, 31) is longer than a pulse duration of a pulse of the mode-locked laser (10).

8. Electronic circuit according to Claim 6 or 7,
**characterized**
**in that** the delay device (30, 31) consists of a differential pair of third transistors (42, 43), two load resistors (40, 41) and a second current source (44),
**in that** the load resistors (40, 41) are connected between a supply voltage terminal and collectors of the third transistors (42, 43),
**in that** emitters of the third transistors (42, 43) are connected to the second current source (44), and
**in that** base terminals of the third transistors (42, 43) are connected to at least one output (Q, Q') of the multivibrator (13).

9. Electronic circuit according to Claim 8,
**characterized**
**in that** collectors of the third transistors (42, 43) are connected to outputs (Q", Q''') of the electronic switching device.

## Revendications

1. Circuit électronique comportant un circuit de bascule (13), un dispositif de commutation (12), une photodiode (14) et un laser à mode bloqué (10),
dans lequel le laser en mode bloqué (10) génère des impulsions lumineuses,
dans lequel les impulsions lumineuses génèrent un courant photoélectrique dans la photodiode (14),
dans lequel le dispositif de commutation (12) transmet directement ou indirectement le courant photoélectrique à une des deux entrées (R', S') du circuit de bascule (13), et
dans lequel le circuit de bascule (13) délivre son état à au moins une sortie (Q, Q'),
**caractérisé en ce que**
le dispositif de commutation (12) transmet le courant photoélectrique selon une position de commutation à l'une des deux entrées (R', S') du circuit de bascule (13), et
**en ce que** la position de commutation du dispositif de commutation (12) dépend d'un signal à une entrée de données (D, D') du commutateur (12).

2. Circuit électronique selon la revendication 1, **caractérisé en ce que**
le dispositif de commutation (12) est constitué d'une paire différentielle de premiers transistors (21, 22) et de deux résistances de charge (23, 24),
**en ce que** les résistances de charge (23, 24) sont montées entre une borne de tension d'alimentation et les collecteurs des premiers transistors (21, 22), et
**en ce que** les émetteurs des premiers transistors (21, 22) sont reliés à la photodiode (14).

3. Circuit électronique selon la revendication 2, **caractérisé en ce que**
les bornes de base des premiers transistors correspondent à l'entrée de données du dispositif de commutation (12).

4. Circuit électronique selon la revendication 2 ou 3, **caractérisé en ce que**
le circuit de bascule (13) est constitué d'une paire différentielle de seconds transistors (26, 27) et d'une première source de courant (28),
**en ce que** la première source de courant (28) est montée entre les émetteurs des seconds transistors (26, 27) et une borne de base,
**en ce que** les bornes de base des seconds transistors (26, 27) sont reliées de façon croisée aux collecteurs des seconds transistors (26, 27), et
**en ce que** les collecteurs des seconds transistors (26, 27) sont reliés respectivement à un collecteur des premiers transistors (21, 22).

5. Circuit électronique selon la revendication 4, **caractérisé en ce que**
un courant photoélectrique de la photodiode (14) est plus grand qu'un courant de la première source de courant (28) lors de l'irradiation avec une impulsion du laser à mode bloqué (10).

6. Circuit électronique selon l'une des revendications 1 à 5, **caractérisé en ce que**
le circuit électronique dispose en outre d'un dispositif à retard (30, 31),
**en ce que** le dispositif à retard (30, 31) est relié à une sortie (Q, Q') du circuit de bascule (13),
**en ce que** le dispositif à retard (30, 31) est relié en outre à une entrée de données (D, D') du dispositif de commutation (12), et
**en ce que** le dispositif à retard (30, 31) transmet un signal de sortie du dispositif de commutation (13) retardé à une entrée de données (D, D').

7. Circuit électronique selon la revendication 6, **caractérisé en ce que**
le retard du dispositif à retard (30, 31) est plus long qu'une durée d'impulsion d'une impulsion du laser à mode bloqué (10).

8. Circuit électronique selon la revendication 6 ou 7, **caractérisé en ce que**
le dispositif à retard (30, 31) est constitué d'une paire différentielle de troisièmes transistors (42, 43), de deux résistances de charge (40, 41) et d'une seconde source de courant (44),
**en ce que** les résistances de charge (40, 41) sont montées entre une borne de tension d'alimentation et les collecteurs des troisièmes transistors (42, 43),
**en ce que** les émetteurs des troisièmes transistors (42, 43) sont reliés à la seconde source de courant (44), et
**en ce que** les bornes de base des troisièmes transistors (42, 43) sont reliées à au moins une sortie (Q, Q') du circuit de bascule (13).

9. Circuit électronique selon la revendication 8, **caractérisé en ce que**
les collecteurs des troisièmes transistors (42, 43) sont reliés aux sorties (Q", Q"') du dispositif de commutation électronique.
